# EUROPEAN PATENT APPLICATION

(11) **EP 1 954 109 A1**
(43) Date of publication of application: **06.08.2008**
(21) Application number: 07300756.9
(22) Date of filing: 31.01.2007
(51) Int. Cl.: H05K 3/18, C23C 18/16

(54) **Formation of metallic portions on a substrate**

(71) Applicant: UNIVERSITE JOSEPH FOURIER, 38041 Grenoble Cédex 9 (FR)
(72) Inventor: Soucemarianadin, Arthur, 07130, SAINT PERAY (FR); Sampath, Srinivasan, 560 094, BANGALORE, KARNATAKA (IN); Subramanian Suriyanarayanan, 627 416, TAMIL NADU (IN)
(74) Representative: de Beaumont, Michel

(57) **Abstract**

The invention concerns a method for forming at least a metal portion on at least one location of a substrate, comprising the steps of forming, according to a sol-gel process, a first fluid including a three-dimensional network of chains of an inorganic polymer and a catalyser adapted to facilitate a deposition reaction of said metal and forming a second fluid including a precursor of said metal; applying at least on said at least one location of the substrate a layer of first fluid; and bringing the second fluid into contact with said layer at said at least one location such that a reaction which results in the deposition of said metal from said precursor at said at least one location is catalyzed by the catalyser.

## Description

### FIELD OF THE INVENTION

The present invention relates to the formation of metallic portions, in particular metallic tracks, on the surface of a substrate.

### BACKGROUND OF THE INVENTION

For many applications, it is desirable to form, on the surface of a substrate, metallic coating portions according to various patterns by conventional printing methods, for example by coating, by jetting or by stamping, such methods having the advantage of being cost effective and easy to implement. One application corresponds, for example, to the formation of metallic tracks for the connection of electric components.

For forming such metallic portions, one option is to use an ink containing suspended metallic particles. Once the ink has been deposited on the surface of the substrate according to the desired patterns, the substrate is heated to temperatures of about 150°C to 200°C or even higher in order to obtain an appropriate conductivity. This results in the metallic particles being melted together and allows a good conductive material to be obtained. Choice of proper inks for these methods is very important as equally as the resolution of the technique. The inks should have the properties such as viscosity, surface tension and evaporation rate which should be compatible with the methodology. The ink neither should get clogged at the nozzle in the inkjet jetting method nor should it react with the printing stamp in the microstamping method. There are several approaches to formulate these liquid precursors. Organometallic compound or polymers have been used by dissolving in volatile organic compounds like alcohol or hexane. It should be noted that all the organic constituents should be volatile so that the desired metals are deposited by heating the substrate at high temperature. The major drawback of these techniques is that, for some applications, it may be desirable to form the substrate with a material which is not compatible with the application of high temperatures. That is the case, for example, for some plastic materials. It is then not possible to implement the method previously described.

Formation of metallic tracks can also be made through electroless deposition of metals by autocatalytic redox reactions. This is a room temperature process which enables the patterning on plastics, polymers and paper. The plating process is carried out in the presence of a catalyst, for example palladium (II) ions immobilized on surfaces to initiate the reaction. There need to be an immobilizing agent to serve this purpose. Different materials like thin films, polyelectrolyte, dendrimers and polymers have been tried out as immobilizers for catalyst in lithography. These immobilizers must not react with catalyst and deposition compounds.

However, there is no liquid precursor which can be used for both jetting and microstamping methods. Also depending on the substrates and methods, inking materials have to be changed. For example palladium catalyst in ethanol which is being used as ink in inkjet method is not appropriate for other methods such as microstamping.

### SUMMARY OF THE INVENTION

The present invention aims at a method for forming metallic portions on a substrate which is compatible with conventional printing techniques, in particular both jet printing and micro-contact printing methods, and which can be implemented at low or moderate temperatures.

The present invention aims also at a method for forming metallic portions on a substrate which is easy to implement.

To attain these purposes and others, the present invention provides a method for forming at least a metal portion on at least one location of a substrate, comprising the steps of forming, according to a sol-gel process, a first fluid including a three-dimensional network of chains of an inorganic polymer and a catalyser adapted to facilitate a deposition reaction of said metal and forming a second fluid including a precursor of said metal; applying at least on said at least one location of the substrate a layer of first fluid; and bringing the second fluid into contact with said layer at said at least one location such that a reaction which results in the deposition of said metal from said precursor at said at least one location is catalyzed by the catalyser.

According to an embodiment, the method includes, before the second fluid is brought into contact with said layer, the step comprising cleaning the substrate to remove at least a part of the chains of the inorganic polymer from said layer.

According to an embodiment, the formation of the first fluid comprises the steps of forming a first solution by mixing water and an alkoxide in an alcoholic solution, said alkoxide having the formula M(OR)ₙ where M is a metal or silicon, R is an alkyl group and n is an integer superior to zero; and mixing a catalytic solution containing the catalyser with said first solution.

According to an embodiment, the alkoxide is an alkoxy silane, for example the tetraethoxysilane, or a chloro silane.

According to an embodiment, the catalytic solution is an acid solution containing colloids of palladium and tin.

According to an embodiment, the second fluid is a solution containing ions of said metal.

According to an embodiment, the first fluid is deposited on the substrate by injection or stamping.

According to an embodiment, the second fluid is deposited at said at least one location on said layer of first fluid by injection or stamping.

According to an embodiment, the formation of said layer of first fluid at least on said at least one location of the substrate comprises the steps of forming on the substrate, in regions where the metal portion is not to be formed, patterns of a material adapted to be removed; completely covering the substrate with the first fluid; and removing the patterns of said material and the part of the first fluid covering said patterns.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings.
Figure 1 illustrates, in the form of a block diagram, the successive steps of an example of a method for forming metallic portions on the surface of a substrate according to the invention;
Figures 2A to 2D illustrate the successive steps of a more detailed example of a method for forming metallic portions according to the invention;
Figures 3 and 4 are photos of examples of metallic portions obtained with the method according to the invention;
Figures 5A to 5E illustrate the successive steps of another more detailed example of a method for forming metallic portions according to the invention;
Figure 6 shows an example of inked patterns used with the method illustrated on Figures 5A to 5E; and
Figures 7A to 7C illustrate the successive steps of another more detailed example of a method for forming metallic portions according to the invention.

### DETAILED DESCRIPTION OF THE INVENTION

For clarity, the same elements have been designated with the same reference numerals in the different drawings.

The method for forming metallic portions on the surface of a substrate according to the present invention consists in using two fluids, hereafter called fluid A and fluid B. Fluid A is obtained by a sol-gel process which results in the formation of a solution more or less viscous, in some cases a gel, comprising a network of chains of an inorganic polymer at the level of which is dispersed a catalyser for the reaction resulting in deposition of the metal from which the metallic portions are desired to be made of. Portions of layer of fluid A, hereafter called portions of fluid A, are formed on the surface of the substrate, for example having the same form and the same disposition as the metallic portions that are desired to be obtained. Fluid B is a solution which comprises a precursor of the metal. When fluid B is brought into contact with the portions of fluid A, metal is formed at the locations where fluid B is in contact with fluid A.

An advantage of such a method is that the application of fluids A and B on the substrate can be performed by easy implemented processes, in particular by conventional printing methods, for example by injection or by stamping. Moreover, the steps of the method can be performed at temperatures inferior to 50°C. This allows the substrate to be made from materials which are sensitive to heat.

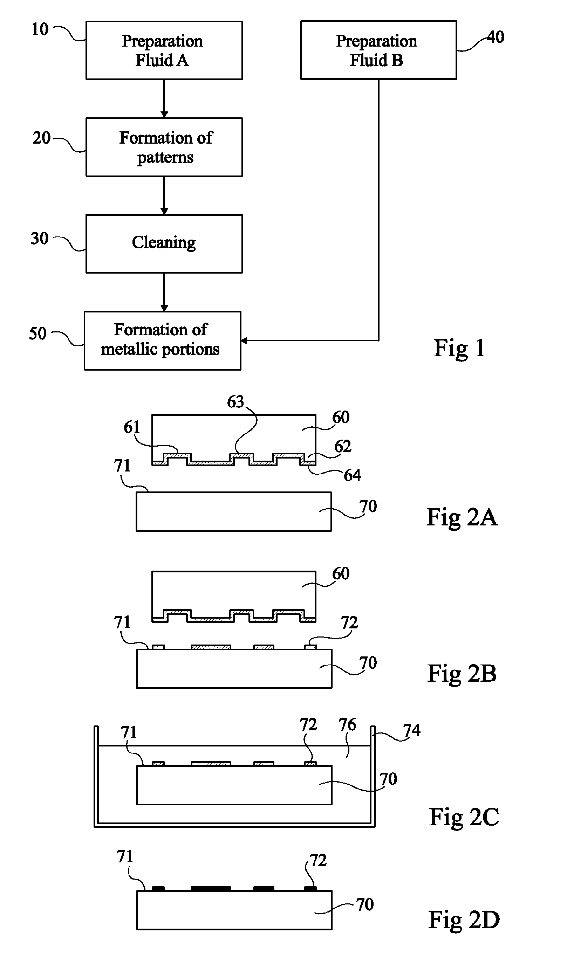

Figure 1 is a block diagram showing the steps of an exemplary method for forming metallic portions according to the present invention.

At step 10, fluid A is prepared according to a sol-gel process. To do so, an alkoxide having the formula M(OR)ₙ is prepared where M is a metal or silicon, n is an integer superior to zero and R is an alkyl organic group having the formula CₘH₂ₘ₊₁, m being an integer which may be equal to one or a higher number. When the precursors are placed in the presence of water, the following chemical reactions are triggered: first the hydrolysis of the alkoxy groups and then the condensation of the hydrolysed product which leads to the gelling of the solution.

By way of example, the precursor comprises tetraethoxysilane Si(OC₂H₅)₄ (also called TEOS) in an alcoholic solution. In the case of this precursor, the hydrolysis reaction is the following:

Si(OC₂H₅)₄+4H₂O -> Si(OH)₄+4C₂H₅OH

The water introduced in the alcoholic solution of TEOS then hydrolyses the ethoxy groups in silanol groups (Si-OH) and produces ethanol.

The condensation reaction is the following:

2Si(OH)4 -> Si(OH)₃-O-Si(OH)₃+H₂O

The condensation reaction forms siloxane bridges (Si-O-Si) from the condensation of two silanol groups and releases a molecule of water. Such a reaction can also take place between an ethoxy group and a silanol group to form a siloxane bridge and release a molecule of ethanol. In the three-dimensional molecular network so obtained, the base element is a tetrahedron (SiO₄⁴⁻) at the center of which is located the central atom of silicon, each base element being linked to other base elements by siloxane bridges. The competition between hydrolysis and condensation sets the equilibrium between the growth of dense particles and their bonding. It also sets, at the nanometer scale, the geometry of the obtained structures. This competition can be chemically controlled by the pH or the salinity of the solution or can be mechanically controlled by mixing the solution more or less vigorously and for a shorter or longer duration so that diffusion of the species helps in completing the reaction at a faster rate.

Before or after the beginning of the hydrolysis and condensation reactions, a catalytic solution is added to the solution previously described, the catalytic solution containing a compound adapted to catalyse the reaction resulting in the deposition of the metal from which the metallic portions are desired to be made. Fluid A finally obtained corresponds then to a three-dimensional network more or less dense made of chains of an inorganic polymer in which the catalytic solution is dispersed.

By way of example, for the preparation of fluid A, 5 ml of TEOS and 6 ml of ethanol are used, the solution being vigorously mixed at 50°C for a period of 2 minutes. About 1.4 ml of distilled water is added, the obtained solution being mixed vigorously. To this solution, a small quantity of concentrated hydrochloric acid (two or three drops) is added in order to initiate the sol-gel reaction at about 50°C. Indeed, the hydrolysis reaction is catalysed in acid medium. The whole solution is then mixed vigorously for 5 minutes.

For the preparation of copper portions, the catalytic solution added to the previously obtained solution corresponds, for example, to a solution comprising palladium and/or tin in a colloidal form in an acid medium. Such a solution is for example described in the article "Electroless Deposition of Cu on Glass and Patterning with Microcontact Printing" of Emmanuel Delamarche, James Vichiconti, Shawn A. Hall, Matthias Geissler, William Graham, Bruno Michel and Ronald Nunes (Langmuir 19(17), 6567-6569, 2003). This solution is for example obtained by mixing initial acid solutions of palladium chloride PdCl₂ and stannous chloride SnCl₂. In this solution, tin and/or palladium are in the form of clusters or colloids having a diameter from several nanometres to several tens of nanometres.

By way of example, 1 ml of the catalytic solution is added to the previously obtained solution and the whole solution is mixed again. The solution finally obtained corresponds to fluid A. The more the solution is mixed, the higher the viscosity of fluid A. Moreover, for obtaining thin and robust depositions of fluid A, a salt such as hydrofluoboriacid can be added, with, for example, a concentration of 0.15 g/l. After waiting for 10 minutes, the condensation reaction is over and fluid A can be used. In the present example, fluid A corresponds then to a more or less dense network of siloxane chains that traps the solvent and the palladium and tin based colloids. The method continues at step 20.

At step 20, portions of fluid A are formed on a substrate. The portions of fluid A can have the same form and the same disposition as the metallic portions which are desired to be obtained or can correspond to a layer of fluid A at least partially covering the substrate. By way of example, the substrate can correspond to a glass slide, a polypropylene sheet, a plastic material, a glassy sheet, a silicon wafer, etc. The formation of the portions of fluid A can be achieved by any conventional methods. By way of example, when the substrate is desired to be covered with a layer of fluid A, the substrate can be directly dipped in fluid A. According to another example, conventional printing methods by ink-jetting can be used, wherein fluid A acts as the ink. According to another example, printing methods by stamping can be used, the stamp being impregnated with fluid A and then applied to the substrate such that it leaves portions of fluid A on the substrate according to the patterns of the stamp. Viscosity of fluid A is adapted to the method implemented to form the portions of fluid A. By way of example, for an ink jet printing method, fluid A with a low viscosity will be preferably used. Conversely, for a stamping printing method, fluid A with a high viscosity will be preferably used. The portions of fluid A then dry quickly, usually within a few minutes, by evaporation of the solvent contained therein. Simultaneously, palladium and/or tin colloids tend to anchor, by adsorption, to the surface of the substrate. The method continues at step 30.

At step 30, a cleaning of the substrate is performed. This step comprises removing a part or the totality of the network of chains of inorganic polymer, in order to leave, in the regions where fluid A is present, catalytic portions on the substrate containing essentially the catalyser of the metal deposition reaction. By way of example, this step can be achieved by cleaning the surface of the substrate with distilled water. The cleaning step may not always be necessary. Indeed, in some cases, the drying of the portions of fluid A leads to the at least partial destruction of the network of the chains of the inorganic polymer owing to stresses, resulting from the capillarity forces, which appear during the progression of the liquid-vapor interface inside the pores of the gel. The method continues at step 40.

At step 40, which can be performed before, after or simultaneously with any of the previously described steps, the fluid B containing the metallic precursor is prepared. By way of example, when the deposition of copper is desired to be performed, fluid B can correspond to a solution comprising copper sulphate 13 g/l, sodium hydroxide 12 g/l, potassium tartarate (KNaC₄H₄O₆.4H₂O) 29 g/l, formaldehyde 9.5 ml/1 and water respectively with the proportions 1:1:1:1:5 by volume. The method continues at step 50.

At step 50, fluid B is brought into contact with the catalytic portions located on the substrate. The catalyser then improves the reaction according to which the metallic precursor contained in fluid B is deposited in metallic form on the substrate in the regions where fluid B makes contact with the catalytic portions. The application of fluid B in the regions of the catalytic portions can be made by dipping the substrate in fluid B, by locally injecting fluid B on the catalytic portions or by stamping fluid B on the catalytic portions.

According to the previously described example, the step of metal deposition corresponds to the transformation of the adsorbed portions containing palladium-tin colloids into conductive portions rich with copper. Palladium-copper portions are obtained which are remarkably resistant to chemical attacks. Moreover, the applicant has found that the palladium-copper portions have substantially the same conductivity as bulk copper.

In a general way, the nature of the catalyser in fluid A and of the metallic precursor in fluid B depends on the metal which is desired to be obtained, for example nickel, tin, gold, silver, etc. Moreover, the adhesion properties of fluid A, in particular the hydrophobic or hydrophilic properties of fluid A, are adapted to the nature of the substrate on which the portions of fluid A are formed.

Figures 2A to 2D illustrate the successive steps of a more detailed example of a method for forming metallic portions on a substrate by stamping.

As shown in Figure 2A, a stamp 60 is used comprising a face 61 on which protruding regions 62 and recessed regions 63 are provided, the protruding regions 62 being placed according to the patterns of the metallic portions which are desired to be obtained. Any kind of stamp can be used. For example, the minimal dimensions of protruding regions 62 of the stamp 60 can be in the order of several tens of micrometers. The face 61 of stamp 60 was dipped in fluid A in order to be covered with a layer 64 of fluid A. A substrate 70 comprising a face 71 on which metallic portions are desired to be formed is placed opposite stamp 60, face 71 of substrate 70 facing face 61 of stamp 60.

As shown in Figure 2B, stamp 60 is applied against substrate 70 and then taken away from it. Hence, the portions of fluid A located on the protruding regions 62 of stamp 60 are deposited on face 71 of substrate 70 to form portions 72 of fluid A having the same form as the metallic portions which are desired to be obtained. After portions 72 have dried, face 71 of substrate 70 is cleaned with distilled water in order to, at least partially, eliminate from portions 72 the chains of inorganic polymer and leave substantially only the catalyser adsorbed on face 71.

As shown in Figure 2C, substrate 70 is dipped in a container 74 filled with a solution 76 of fluid B. As previously described above, a chemical reaction occurs leading to the deposition of metal at the level of portions 72.

Figure 2D shows the structure obtained once the substrate 70 is withdrawn from the container 74. Portions 72 then have the desired electrical conductive properties.

With printing methods such as stamping, it is very important that the ink on the stamp should not get dried very soon and also it should not spread. In this case we have to make the ink viscous enough and apply over the ink pad. It is a room temperature process performed without any immobilizers on the substrate. The conductivity obtained at the end is close to the bulk metal and the ink adheres well to the substrate. Depending on the substrates wetting behaviour, the ink characteristics can be varied as it is explained in more details hereafter.

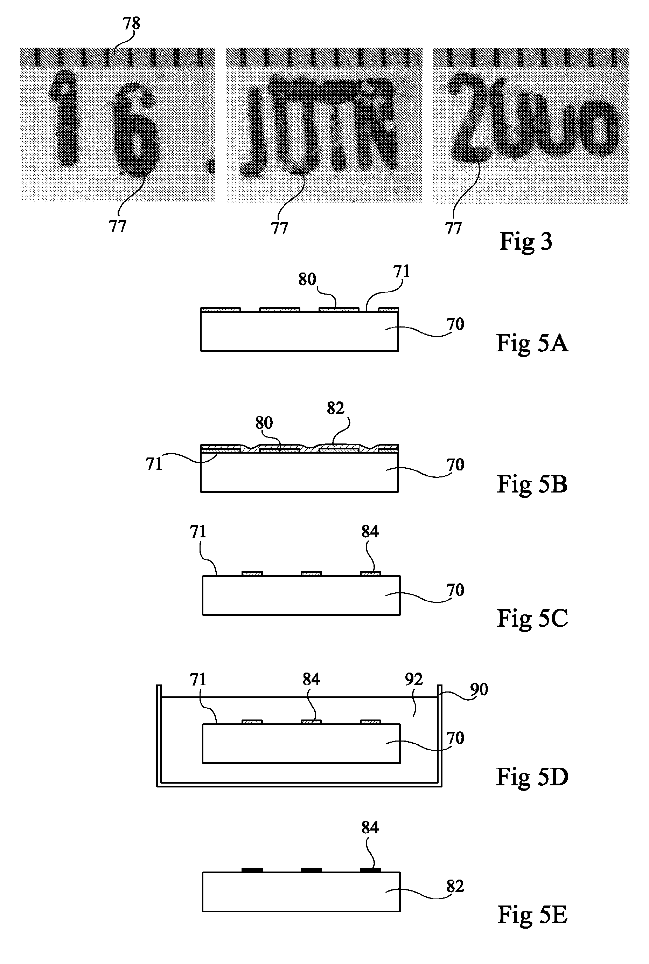

Figure 3 shows the patterns 77 made using contact printing with usual rubber stamp followed by copper deposition on smart cards. The scale 78 shown on Figure 3 is graduated in millimetres.

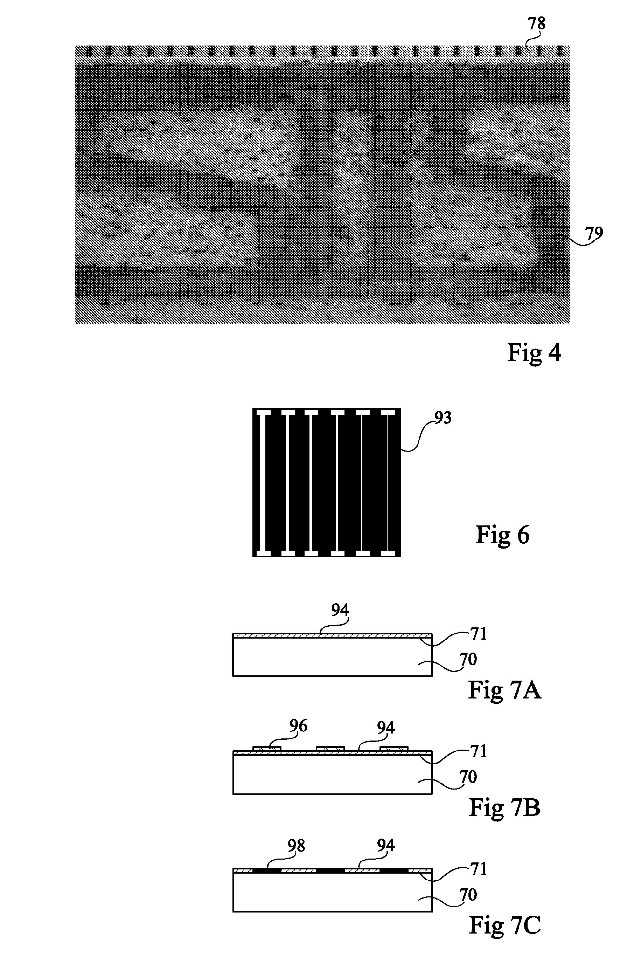

Figure 4 shows one pattern 79 made on smart cards using spray technique (called Flat Jet) followed by copper deposition at room temperature. The scale 78 shown on Figure 4 is graduated in millimetres. The specific spray printing method for example works based on a piezoceramic transducer attached to a cone shaped nozzle, an ink reservoir being provided at the other end of the nozzle. The patterning ink is loaded in the reservoir and the patterns are made by software control which makes the jet to move in the x-y direction. The overall time to obtain the conductive pattern shown of Figure 4 is much less than 2 minutes and the conductivity is close to the bulk metallic copper. Since the whole process can be performed at room temperature, low melting substrates like polymer and plastics can be used to make conductive patterns. Also the concentration of the catalyst can be varied which give desired thickness of the pattern. With low concentration of the ink, non uniform coating of copper in the patterned areas can be obtained. This allows the formation of conductive patterns of desired resistance.

With digital printing methods such as ink-jet printing, the coalescence of neighbouring drops is very important depending on the nature of wetting characteristics of the substrate. For example, on glass slides, the coalescence or spreading is very effective even at room temperature. With a substrate of highly wetting nature, the ink should be slightly viscous so that the spreading can be avoided. This can be done by increasing the temperature and time of stirring while preparing the ink. Also if the substrate is highly dewetting or hydrophobic then proper silane precursor like hydrophobic silane should be used for the ink preparation. This is much feasible process because, MTMOS which is hydrophobic in nature can also undergo sol-gel process and so it can be used in the ink preparation for hydrophobic substrates instead of TEOS for substrates of hydrophilic nature.

Figures 5A to 5E illustrate the successive steps of another more detailed example of a method for forming metallic portions on a substrate.

As shown in Figure 5A, inked patterns 80 are printed on face 71 of substrate 70 by conventional printing methods by ink injection or stamping. The inked patterns 80 form a mask. In particular, the ink can have a conventional composition. The inked patterns 80 are provided at the locations where no metallic portion is to be made.

As shown in Figure 5B, face 71 of substrate 70 is completely covered with a layer 82 of fluid A. To do so, substrate 70 can be dipped in a solution of fluid A.

As shown in Figure 5C, inked patterns 80 are removed, for example by applying a solvent such as acetone on face 71 of substrate 70. The removal of the inked patterns 80 leads to the removal of the parts of the layer 82 of fluid A covering the inked patterns 80. Hence, there remains, on face 71, the portions 84 of fluid A which were not covering inked patterns 80. Portions 84 of fluid A are then at the same locations as the metallic portions which are desired to be obtained. Face 71 of substrate 70 is then cleaned with distilled water in order to eliminate, at least partially, from portions 84 the inorganic polymer and leave substantially only the catalyser adsorbed on face 71.

As shown in Figure 5D, substrate 70 is dipped in a container 90 filled with a solution 92 of fluid B. As previously described, a chemical reaction takes place leading to the deposition of metal at the level of portions 84.

Figure 5E shows the obtained structure once substrate 70 is withdrawn from the container 90. Portions 84 have then the desired electrical conductive properties.

An alteration of the method previously described in relation to Figures 5A to 5B includes the following steps:
- the mask is printed on a substrate, for example a plastic sheet, using a standard laser printer;
- the substrate is dipped in a Tetra ethoxyorthosilicate (TEOS) and ethylalcohol bath with palladium catalyst solution;
- the pattern is then removed and washed with deionized water;
- the pattern is ultrasonicated in a fresh bath of organic solvent and washed again with deionized water. This step removes the toner as well as the metallic precursor. The portions with no toner but only metallic precursor in sol-gel form are not attacked and are left unchanged; and
- the pattern is finally dipped in the copper sulphate solution during sufficient time for metallization to occur.

With the previously described method, lines of different widths and different lengths have been printed. This method enables to print very low cost electronics on plastics and other low priced substrates.

Figure 6 shows an example of a mask which can be used at step 5A for printing conductive lines. The black areas 93 will ultimately be the areas not coated by the metal and hence will not be conductive. Conductive lines having a width of 50 µm were obtained with the previously described method.

Figures 7A to 7C illustrate the successive steps of another example of a method for forming metallic portions on a substrate.

As shown in Figure 7A, face 71 of substrate 70 is completely covered with a layer 94 of fluid A. To do so, substrate 70 can be dipped in a solution of fluid A. Once dried, layer 94 of fluid A can be cleaned, for example with distilled water, in order to leave a catalytic layer comprising principally the catalyser initially present in fluid A and adsorbed on face 71 of substrate 70.

As shown in Figure 7B, portions 96 of fluid B are formed on layer 94, portions 96 of fluid B having the same form as the metallic portions which are desired to be obtained. By way of example, portions 96 of fluid B can be formed by conventional printing methods by injection or by stamping.

As shown in Figure 7C, the chemical reaction resulting in metal deposition occurs at the locations where layer 94 makes contact with portions 96 of fluid B, leading to the formation, in layer 94, of portions 98 having the desired electrical conductive properties.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. A method for forming at least a metal portion (72; 84; 98) on at least one location of a substrate (70), comprising:
forming, according to a sol-gel process, a first fluid including a three-dimensional network of chains of an inorganic polymer and a catalyser adapted to facilitate a deposition reaction of said metal and forming a second fluid including a precursor of said metal;
applying at least on said at least one location of the substrate a layer of first fluid (72; 84; 94); and
bringing the second fluid into contact with said layer at said at least one location such that a reaction which results in the deposition of said metal from said precursor at said at least one location is catalyzed by the catalyser.

2. The method according to claim 1, including, before the second fluid is brought into contact with said layer (72; 84; 94), the step comprising cleaning the substrate (70) to remove at least a part of the chains of the inorganic polymer from said layer.

3. The method according to claim 1, wherein the formation of the first fluid comprises:
forming a first solution by mixing water and an alkoxide in an alcoholic solution, said alkoxide having the formula M(OR)ₙ where M is a metal or silicon, R is an alkyl group and n is an integer superior to zero; and
mixing a catalytic solution containing the catalyser with said first solution.

4. The method according to claim 3, wherein the alkoxide is an alkoxy silane, for example the tetraethoxysilane, or a chloro silane.

5. The method according to claim 3, wherein the catalytic solution is an acid solution containing colloids of palladium and tin.

6. The method according to claim 1, wherein the second fluid is a solution containing ions of said metal.

7. The method according to claim 1, wherein the first fluid is deposited on the substrate (70) by injection or stamping.

8. The method according to claim 1, wherein the second fluid is deposited at said at least one location on said layer (72; 84; 94) of first fluid by injection or stamping.

9. The method according to claim 1, wherein the formation of said layer (72; 84; 94) of first fluid at least on said at least one location of the substrate comprises:
forming on the substrate (70), in regions where the metal portion (72; 84; 98) is not to be formed, patterns (80) of a material adapted to be removed;
completely covering the substrate with the first fluid; and
removing the patterns of said material and the part of the first fluid covering said patterns.
